# EUROPÄISCHE PATENTSCHRIFT

(11) **EP 3 947 242 B1**
(45) Veröffentlichungstag und Bekanntmachung des Hinweises auf die Patenterteilung: **09.10.2024**
(21) Anmeldenummer: 20714458.5
(22) Anmeldetag: 03.04.2020
(51) Int. Cl.: B66C 15/06, B66C 23/90, E02F 9/20, B66C 13/40, B66C 23/94, B66C 15/04, E02F 9/26, E02F 9/24

(54) **VERFAHREN UND VORRICHTUNG ZUM STEUERN EINER MATERIALUMSCHLAGS- UND/ODER BAUMASCHINE**
METHOD AND DEVICE FOR CONTROLLING A MATERIAL HANDLING AND/OR CONSTRUCTION MACHINE
PROCÉDÉ ET DISPOSITIF POUR COMMANDER UNE MACHINE DE TRANSBORDEMENT DE MATÉRIAUX ET/OU UN ENGIN DE CONSTRUCTION

(30) Priorität: 03.04.2019 DE 102019108689
(43) Veröffentlichungstag der Anmeldung: 09.02.2022
(73) Patentinhaber: Liebherr-Werk Biberach GmbH, 88400 Biberach an der Riss (DE)
(72) Erfinder: BRENNER, Stefan, 89264 Weißenhorn (DE); HOFMEISTER, Markus, 88447 Warthausen (DE)
(74) Vertreter: Thoma, Michael
(86) Internationale Anmeldenummer: PCT/EP2020/059489
(87) Internationale Veröffentlichungsnummer: WO 2020/201473

(56) Entgegenhaltungen:
- EP-A1- 3 556 712
- DE-A1- 102016 012 786
- DE-A1- 102017 110 715
- DATABASE WPI Week 200842, Derwent World Patents Index; AN 2008-G64720, XP002799616

## Beschreibung

Die vorliegende Erfindung betrifft ein Verfahren und eine Vorrichtung zum Steuern einer Materialumschlags- und/oder Baumaschine wie Kran oder Seilbagger, wobei auf einem Bildschirm einer Steuervorrichtung mit Touchscreen-Funktion verschiedene Steuerfunktionen durch Berühren eines Steuerfunktionssymbols ausgewählt und Funktionsparameter einer jeweils ausgewählten Steuerfunktion eingestellt werden. Die Erfindung betrifft ferner auch eine Materialumschlags- und/oder Baumaschine wie Kran oder Seilbagger mit einer solchen Steuervorrichtung.

Eine solche Steuervorrichtung ist beispielsweise aus der Schrift DE 10 2016 012 786 A1 oder auch aus der Schrift RU 2326806 C1 bekannt. Eine ähnliche Steuervorrichtung zeigt auch die Schrift DE 10 2017 110 715 A1.

Für die Steuerung von Baumaschinen wie Kranen oder Seilbaggern oder anderen Materialumschlagsmaschinen wie Surface Minern werden in jüngerer Zeit zunehmend Steuervorrichtungen mit Touchscreen-Bildschirmen eingesetzt, um eine intuitivere Bedienung zu ermöglichen. Um die Steuerung übersichtlich zu halten und die Bildschirmdarstellung nicht mit im Moment nicht benötigten Details zu überfrachten, kann eine Menü-Steuerung vorgesehen werden, die verschiedene Steuerungsfunktionen auswählbar macht und nach Auswahl auf dem Bildschirm größer oder zusätzlichen Informationen nach Art eines aufpoppenden Bildschirm-Fensters darstellt. Beispielsweise können in einer schmalen Randleiste der Bildschirmdarstellung verschiedene Steuerungsfunktionssymbole angezeigt werden, um durch Antippen eines Steuerungsfunktionssymbols eine spezielle Steuerungsfunktion auszuwählen. In der jeweils ausgewählten Steuerungsfunktion können dann Funktionsparameter eingestellt oder verändert werden, indem über den Touchscreen-Bildschirm entsprechende Informationen eingegeben werden.

Durch diese Auswählbarkeit verschiedener Steuerfunktionen wird einerseits die Übersichtlichkeit der Bildschirmdarstellung verbessert. Andererseits wird aber auch eine Fehlbedienung verhindert bzw. zumindest erschwert, da nicht unbeabsichtigt durch versehentliches Berühren des Touchscreen-Bildschirms Steuerungsparameter verstellt werden.

Eine Steuervorrichtung mit Touchscreen-Oberfläche für einen Kran ist beispielsweise aus der Schrift DE 10 2014 216 982 A1 bekannt, wobei hier zur Vermeidung ungewollter Steuerbefehle durch unbeabsichtigtes Berühren der Touchscreen-Oberfläche vorgeschlagen wird, einen zusätzlichen Betätigungsknopf zum Betätigen von Steuerbefehlen zu verwenden, der durch einen zusätzlichen, an den Tablet-Computer andockbaren Hardware-Baustein realisiert ist.

Eine weitere Steuervorrichtung mit Touchscreen-Bildschirm für einen Kran zeigt die Schrift DE 10 2016 012 786 A1, wobei darin vorgeschlagen ist, Verfahrbewegungen des Krans durch beispielsweise Antippen des Lasthakens und Verschieben des Lasthakens auf dem Bildschirm zu steuern.

Trotz der genannten Bemühungen unter Verwendung von Touchscreen-Oberflächen sind etliche Steuerungsfunktionen von Baumaschinen immer noch schwierig zu bedienen. Aufgrund der komplexen Maschinenfunktionen sind die Auswirkungen einzelner Funktionsparameter und deren Verstellung oft schwierig abzuschätzen, sodass gerade bei sicherheitsrelevanten Funktionen für deren Einstellung immer noch auf einen klassischen Teach-in-Prozess durch einen sehr erfahrenen Maschinenführer vertraut wird. Sollen beispielsweise die Arbeitsbereichsgrenzen beim Aufstellen eines Krans programmiert werden, werden von dem erfahrenen Kranführer die Drehstellungen und Wippstellungen des Auslegers angefahren, um dann die angefahrene Stellung als Arbeitsbereichsgrenze abzuspeichern, sodass der Kran bei erneutem Anfahren bzw. Erreichen der Grenze im regulären Betrieb abbremst und/oder stoppt. In ähnlicher Weise ist es auch bei anderen Steuerungsfunktionen selbst für erfahrene Maschinenführer schwierig, die gewünschten Funktionsparameter passend einzustellen, insbesondere wenn es sich um nicht täglich genutzte Steuerungsfunktionen handelt, beispielsweise die Einstellung der Betriebsparameter für verschiedene Windsituationen oder der Ballastierung für verschiedene Windzonen.

Der vorliegenden Erfindung liegt die Aufgabe zugrunde, eine verbesserte Materialsumschlags- und/oder Baumaschine der genannten Art sowie ein verbessertes Verfahren und eine verbesserte Vorrichtung zu deren Steuerung zu schaffen, die Nachteile des Standes der Technik vermeiden und letzteren in vorteilhafter Weise weiterbilden. Insbesondere soll eine erleichterte Bedienung komplexer Steuerungsfunktionen solcher Materialumschlags- und/oder Baumaschinen erreicht werden. Erfindungsgemäß wird die genannte Aufgabe durch ein Verfahren gemäß Anspruch 1, eine Vorrichtung gemäß Anspruch 7 sowie eine Materialumschlags- und/oder Baumaschine gemäß Anspruch 13 gelöst. Bevorzugte Ausgestaltungen der Erfindung sind Gegenstand der abhängigen Ansprüche.

Es wird nach einem bevorzugten Aspekt der vorliegenden Anmeldung zunächst vorgeschlagen, den Touchscreen-Bildschirm für die Einstellung der üblicherweise schwierig handzuhabenden Arbeitsbereichs-Begrenzungsfunktion zu verwenden, wobei der Touchscreen-Bildschirm nicht etwa nur zum Eingeben eines Abspeicherbefehls zum Speichern einer tatsächlich angefahrenen Maschinenposition verwendet wird, sondern ein virtuelles Verschieben und/oder Formen der Arbeitsbereichsgrenze auf dem Bildschirm selbst erfolgt, um ein tatsächliches Anfahren der Begrenzungspositionen in einem aufwändigen Teach-In-Prozeß zu vermeiden. Vorzugsweise wird eine Arbeitsbereichsgrenze der Arbeitsbereichs-Begrenzungsfunktion, die zumindest einen Verstellantrieb bei Erreichen der Arbeitsbereichsgrenze automatisch abschaltet und/oder verlangsamt, auf dem Bildschirm zusammen mit einer Darstellung der Materialumschlags- und/oder Baumaschine und/oder deren Arbeitsumgebung in Form eines Touchscreen-Anzeigeelements angezeigt, sodass die Arbeitsbereichsgrenze durch Berühren und Verschieben auf dem Bildschirm relativ zu der Materialumschlags- und/oder Baumaschine und/oder deren Arbeitsumgebung eingestellt werden kann. Die Arbeitsbereichsgrenze, deren Lage und Kontur durch die Darstellung zusammen mit der Maschine und deren Arbeitsumgebung dem Maschinenführer gut ersichtlich ist, kann durch Antippen auf dem Bildschirm für eine Verstellung aktiviert und durch Verschieben auf dem Bildschirm verändert werden, sodass die Arbeitsbereichsgrenze nicht mehr durch eine tatsächliche Maschinenbewegung angefahren und die angefahrene Stellung als Arbeitsbereichsgrenze gemerkt werden muss. Vielmehr erfolgt die Festlegung der Arbeitsbereichsgrenze virtuell auf dem Touchscreen-Bildschirm vor dem Hintergrund der auf dem Touchscreen-Bildschirm angezeigten Materialumschlags- und/oder Baumaschine und/oder deren Arbeitsumgebung.

In Weiterbildung der Erfindung kann nicht nur die Position und Ausrichtung der Arbeitsbereichsgrenze, sondern auch deren Kontur bzw. Form auf dem Touchscreen-Bildschirm verändert werden. Je nachdem, welche Hindernisse zu berücksichtigen sind und welche Verstellmöglichkeiten die Baumaschine bzw. die Materialumschlagsmaschine bietet, kann durch Berühren des Touchscreen-Bildschirms und dessen Bildschirmsteuerungsfunktionen wahlweise ein gerader Verlauf der Arbeitsbereichsgrenze in einen gekrümmten, bogenförmigen Verlauf oder umgekehrt verändert werden. Alternativ oder zusätzlich kann beispielsweise auch die Kontur, das heißt der Umrissverlauf eines Arbeitsbegrenzungsbereichs beispielsweise von einem Kreissektor in einen rechteckigen Begrenzungsbereich oder dieser wiederum in einen dreieckigen Begrenzungsbereich verändert werden, indem die Touchscreen-Bildschirmoberfläche berührt und die Kontur der angezeigten Arbeitsbereichsgrenze verändert wird.

Um nicht mühsam von Null beginnend den gesamten Konturverlauf durch Antippen und Wischen auf dem Bildschirm erzeugen zu müssen, kann in vorteilhafter Weiterbildung der Erfindung auf dem Touchscreen-Bildschirm eine Auswahl von verschiedenen, unterschiedlich geformten Auswahlkonturen für die Arbeitsbereichsgrenze angezeigt werden, sodass durch Berühren einer bestimmten Auswahlkontur auf dem Bildschirm, die der gewünschten Arbeitsbereichsgrenze am nächsten kommt, die Kontur und Form der Arbeitsbereichsgrenze vorkonfiguriert werden kann. Beispielsweise können rechteckige, kreissektorförmige und bogenstreifenförmige Auswahlkonturen auf dem Touchscreen-Bildschirm in Form von Touchscreen-Anzeigeelementen bereitgehalten werden, um Arbeitsbereichsgrenzen für häufig vorkommende Hindernisse wie rechteckige Häuser, Schwenkbereichsgrenzen für einen Kran oder freizuhaltene Straßen bzw. Wege leicht auswählen zu können.

In einem zweiten Konturierungsschritt kann dann die vorausgewählte Kontur fein umgeformt werden, insbesondere durch Verformen und/oder Ergänzen bzw. Umkonfigurieren des vorausgewählten Touchscreen-Element durch Berühren Verschieben bestimmter Anzeigeelemte-Abschnitte auf dem Bildschirm.

Um eine beliebige Anpassung der Form bzw. Kontur einer Arbeitsbereichsgrenze vornehmen zu können, kann das die Arbeitsbereichsgrenze auf dem Bildschirm symbolisierende Touchscreen-Anzeigeelement dazu ausgebildet sein, seine Form durch Berühren und Entlangwischen auf dem Bildschirm zu verändern. Beispielsweise kann das Touchscreen-Anzeigeelement dazu konfiguriert sein, bei Berühren und Verschieben eines Konturpunkts der angezeigten Arbeitsbereichsgrenze auf dem Bildschirm den Verlauf der Kontur so nachzuziehen bzw. anzupassen, dass die Arbeitsbereichsgrenze von zwei benachbarten, nicht verschobenen Konturpunkten zu dem verschobenen Konturpunkt verläuft.

Beispielsweise kann das genannte Touchscreen-Anzeigeelement, das den Verlauf der Arbeitsbereichsgrenze wiedergibt, dazu ausgebildet sein, dass zwei Konturpunkte der Arbeitsbereichsgrenze durch Antippen mittels jeweils eines Fingers auf dem Bildschirm festgehalten werden und ein dazwischenliegender Konturpunkt durch Antippen und Entlangwischen auf dem Bildschirm in eine neue Position verschoben werden kann, und zwar relativ zu den beiden anderen, festgehaltenen Konturpunkten. Die Steuervorrichtung berechnet dann den Verlauf der Arbeitsbereichsgrenze neu, sodass die Arbeitsbereichsgrenze von den beiden festgehaltenen Konturpunkten zu dem neuen, verschobenen Konturpunkt verläuft.

Ein Verschieben der Arbeitsbereichsgrenze bzw. eines Konturpunkts der Arbeitsbereichsgrenze muss dabei nicht zwangsweise durch Entlangwischen auf dem Bildschirm erfolgen, auch wenn dies besonders intuitiv eine feine Steuerung erlaubt. Alternativ oder zusätzlich kann die Touchscreen-Bildschirm-Steuereinrichtung auch dazu ausgebildet sein, ein Verschieben durch Antippen zweier Bildschirmpunkte zu erlauben, beispielsweise dergestalt, dass ein bestimmter Konturpunkt der Arbeitsbereichsgrenze zunächst auf dem Bildschirm angetippt wird, um ihn für eine Verschiebung auszuwählen, wobei sodann durch Antippen eines anderen Punkts des Touchscreen-Bildschirms die neue, gewünschte Position des genannten Konturpunkts festgelegt wird.

Um eine ungewollte Verschiebung der Arbeitsbereichsgrenze oder eines Konturpunkts zu vermeiden, kann vorgesehen sein, dass eine Verschiebung nur auf eine bestimmte Abfolge von Tipp- und/oder Wischbewegungen erfolgt, beispielsweise dergestalt, dass ein bestimmter Konturpunkt zunächst nach Art eines Doppelklicks zweimal angetippt und sodann eine Wischbewegung auf dem Bildschirm erfolgen muss. Alternativ oder zusätzlich kann beispielsweise ein längeres, z.B. über mehr als 5 Sekunden erfolgendes Antippen eines bestimmten Konturpunkts der Arbeitsbereichsgrenze verlangt werden, um ihn für eine Verschiebung auszuwählen und den Verschiebemodus scharf zu stellen. Wird dann ein zweiter, anderer Bildschirmpunkt angetippt, erfolgt die genannte Verschiebung.

Alternativ oder zusätzlich kann ein Veränderung der Konturierung bzw. Form und/oder Position bzw. des Verlaufs einer Arbeitsbereichsgrenze auchdadurch erfolgen, dass ein zusätzlicher Konturpunkt ergänzt wird, woraufhin die Steuereinrichtung durch Berechnung die Arbeitsbereichsgrenze von zwei benachbarten Kunturpunkten ausgehend durch den neuen, ergänzten Konturpunkt legt. Hierdurch kann bspw. in einfacher Weise aus einen dreieckförmigen Begrenzungsbereich ein viereckiger Begrenzungsbereich gemacht werden, oder eine geradlinige Arbeitsbereichsgrenze zu einer abgeknickten, polygonzugartigen Arbeitsbereichsgrenze gemacht werden. Um einen neuen Konturpunkt zu ergänzen, kann beispielsweise in einer randseitigen Menüleiste ein Funktionssymbol "Konturpunkt ergänzen" angeboten werden, durch dessen Berühren der Steuereinrichtung signalisiert wird, dass die nächste Berührung des Bildschirms einen neuen Konturpunkt setzen soll. Grundsätzlich wäre dies aber auch in anderer Weise möglich, bspw. durch eine bestimmte Weise der Berührung des Bildschirms am zu ergänzenden Konturpunkt, bspw. durch dreimaligen Antippen oder zweimaliges Antippen mit längerem Halten des Punkts.

Alternativ oder zusätzlich kann die Steuereinrichtung grundsätzlich verschiedene Veränderungsmodi zum Verändern verschiedener Parameter der Arbeitsbereichsgrenze bzw. des Arbeitsbegrenzungsbereichs in Abhängigkeit verschiedener Bedienungsmodi des Touchscreen-Bildschirms ausführen. Insbesondere kann ein bloßes Verschieben einer Arbeitsbereichsgrenze oder eines Arbeitsbegrenzungsbereichs durch ein anderes Betätigen des Touchscreen-Bildschirms gesteuert werden als ein Verändern der Form bzw. des Konturverlaufs der Arbeitsbereichsgrenze.

Beispielsweise kann durch einmaliges, längeres Antippen über z.B. mehr als 5 Sekunden und anschließendes Entlangwischen auf dem Bildschirm der Konturverlauf der Arbeitsbereichsgrenze verändert werden, beispielsweise indem der Konturpunkt entsprechend verschoben und der Grenzverlauf zu nicht verschobenen Nachbarspunkten nachgerechnet wird. Um die Arbeitsbereichsgrenze oder den gesamten Begrenzungsbereich ohne Veränderung des Konturverlaufs in der Position relativ zur Baumaschine und/oder zu deren Arbeitsumgebung zu verschieben, kann beispielsweise ein zweimaliges oder dreimaliges Antippen der Arbeitsbereichsgrenze oder des Bereichs verlangt werden, woraufhin ein nachfolgendes Entlangwischen auf dem Bildschirm als Verschiebebefehl interpretiert wird.

Alternativ oder zusätzlich kann beispielsweise auch eine Verschiebebewegung auf dem Bildschirm durch einen Finger als Steuerbefehl für die Veränderung eines Konturverlaufs gewertet werden, während zwei voneinander beabstandete Finger, die den Bildschirm berühren und gemeinsam in eine Richtung verfahren, als Steuerbefehl für ein Verschieben ohne Konturveränderung interpretiert werden.

Nach der vorliegenden Anmeldung wird dem Maschinenführer bei komplexeren Parametereinstellungen oder Bedienungsfehlern eine zusätzliche Hilfestellung auf einem zusätzlichen Bildschirm angeboten, um den Einstellprozess auf dem Touchscreen-Bildschirm nicht zu beeinträchtigen oder das Verständnis der dort angezeigten Darstellung durch Überblendung mit einem Hilfsmenü nicht zu beeinträchtigen. Erfindungsgemäß wird zu einer auf dem Touchscreen-Bildschirm jeweils ausgewählten Steuerfunktion ein maschinenlesbarer Code auf dem Touchscreen-Bildschirm angezeigt, der durch Einscannen mittels eines mobilen Endgeräts auf dem mobilen Endgerät zusätzliche Informationen zu der ausgewählten Steuerfunktion anzeigt bzw. deren Anzeige veranlasst. Auf den ersten Blick würde es an sich einfacher erscheinen, auf dem Touchscreen-Bildschirm ein Hilfe- bzw. Informationssymbol anzuzeigen und bei dessen Antippen auf dem Touchscreen-Bildschirm selbst entsprechende Zusatzinformationen anzuzeigen. Allerdings wird durch eine solche Anzeige zusätzlicher Informationen nach Art eines Popup-Windows auf dem Touchscreen-Bildschirm selbst die dort dargestellte Steuerfunktion und deren Erfassbarkeit beeinträchtigt. Durch Anzeige auf einem separaten, mobilen Endgerät kann der Maschinenführer bei Bedarf zusätzliche Informationen auf dem mobilen Endgerät aufrufen und gleichzeitig im Einstellmenü des Touchscreen-Bildschirms weiterarbeiten.

Der maschinenlesbare Code kann beispielsweise ein QR-Code oder gegebenenfalls auch ein Strichcode sein, der auf dem Bildschirm der Steuereinrichtung angezeigt wird und von der Kamera eines mobilen Endgeräts wie beispielsweise eines Tablets oder eines Mobiltelefons eingescannt werden kann. Der am mobilen Endgerät eingescannte Code veranlasst das mobile Endgerät, eine bestimmte Zusatzinformation aufzurufen, die auf dem mobilen Endgerät gespeichert, aber auch über eine Netzwerkverbindung von einem örtlich entfernten Server oder einer Datenbank heruntergeladen werden kann. Beispielsweise kann ein eingescannter QR-Code das mobile Endgerät veranlassen, eine bestimmte Webpage über eine Internetverbindung aufzurufen, die dann die begehrten Zusatzinformationen anzeigt.

In vorteilhafter Weiterbildung der Erfindung kann der maschinenlesbare Code automatisch bei einer Fehlbedienung und/oder bei Eingabe eines unerwarteten Steuerbefehls auf dem Bildschirm der Steuereinrichtung angezeigt werden, gegebenenfalls zusammen mit einem erklärenden Textmeldung, um den Maschinenführer zu veranlassen bzw. darauf hinzuweisen, dass durch Einscannen des angezeigten Codes auf einem mobilen Endgerät zusätzliche Informationen angezeigt werden.

Alternativ oder zusätzlich kann die Steuereinrichtung aber auch derart beschaffen sein, dass der genannte maschinenlesbare Code bei gezielter Anforderung und Eingabe eines entsprechenden Steuerbefehls durch den Maschinenführer angezeigt wird. Beispielsweise kann auf dem Bildschirm der Steuereinrichtung ein Hilfe- und/oder Informationssymbol in Form eines Touchscreen-Anzeigeelements bereitgehalten werden. Bei Berühren bzw. Antippen des genannten Hilfe- und/oder Informationssymbols zeigt dann der Bildschirm der Steuereinrichtung den genannten maschinenlesbaren Code an.

Um dem Maschinenführer eine intuitive Bedienung noch einfacher zu machen, ist es hilfreich, wenn in Weiterbildung der Erfindung die Arbeitsumgebung der Baumaschine der Materialumschlags- und/oder Baumaschine, ggf. zusammen mit der Maschine oder relevanten Teilen hiervon vor dem Hintergrund der Arbeitsumgebung, möglichst realistisch auf dem Bildschirm dargestellt wird.

Hierzu kann die Steuereinrichtung dazu konfiguriert sein, Bilddaten von einer Kamera und/oder digitale Daten aus einem Bauwerkdatenmodell, einem sogenannten BIM zu empfangen, anhand der empfangen Bilddaten der Kamera und/oder der digitalen Daten aus dem Bauwerkdatenmodell eine Darstellung der Maschinenumgebung und/oder eines Arbeitswerkzeugs der Maschine auf dem Bildschirm anzuzeigen, und das Eingabemittel zum Eingeben von Steuerbefehlen in Form des Touchscreen-Elements zumindest zeitweise gleichzeitig zu der Darstelllung der Maschinenumgebung und/oder des Arbeitswerkzeugs auf dem Bildschirm anzuzeigen. Der Bildschirm kann also gleichzeitig als Monitor zum Beobachten der Arbeitsumgebung und/oder des Arbeitswerkzeugs der ferngesteuerten Maschine einerseits und als Steuerungspaneel zum Anzeigen und Eingeben von Steuerbefehlen andererseits ausgebildet sein. Hierdurch kann eine komfortablere und sichere Bedienung erzielt werden, da dem Maschinenführer auch beim Betrachten der Eingabeoberfläche für die Steuerbefehle die Arbeitsumgebung, in der die Einstellungen auszuführen sind, dargestellt wird, ohne dass der Maschinenführer die Blicke dafür hin- und herwenden müsste.

Insbesondere beim zuvor erläuterten Einstellen der Arbeitsbereichsgrenzen ist es hilfreich, diese in bzw. vor der realitätsnah dargestellten Arbeitsumgebund zu sehen, ggf. zusammen mit dem theoretisch möglichen Arbeitsbereich der jeweiligen Maschine.

Die genannten Eingabemittel zum Eingeben von Steuerbefehlen in Form eines Touchscreen-Anzeigeelements können hierbei vorteilhafterweise direkt in die Darstellung der Maschinenumgebung und/oder des Arbeitswerkzeugs nach Art einer überlagerten Darstellung eingeblendet werden, sodass das Touchscreen-Anzeigeelement sozusagen vor dem Hintergrund der dargestellten Arbeits- bzw. Maschinenumgebung auf dem Bildschirm dargestellt wird.

Alternativ oder zusätzlich zu solchen in das Bild der Arbeitsumgebung eingeblendeten Touchscreen-Anzeigeelementen ist es jedoch ebenfalls möglich, auf dem Bildschirm des Tabletcomputers die genannten Touchscreen-Anzeigeelemente zum Eingeben von Steuerbefehlen in einem separaten Fenster darzustellen, das bspw. permanent an einem Bildschirmrand angezeigt oder bei Bedarf nach Art eines Popup-Windows aufrufbar ist und sich über das Fenster der Bilddarstellung der Maschinenumgebung legt.

Vorteilhafterweise kann das auf dem Bildschirm der Steuereinrichtung dargestellte Bild der Maschinenumgebung und/oder des Arbeitsbereichs und/oder des zu erstellenden Bauwerks und/oder des Arbeitswerkzeugs der Maschine auch eine virtuelle Darstellung umfassen, die anhand von Bauwerks- und/oder Baustellendaten aus einem Baustellendatenmodell generiert wird. Die Steuereinrichtung kann hierzu ein grafisches Simulationsmodul zum Berechnen der virtuellen Darstellung aufweisen, wobei ein solches grafisches Simulationsmodul vorteilhafterweise mit einer Datenschnittstelle an der Steuereinrichtung zum Einspielen der Bauwerks- und/oder Baustellendaten verbunden sein kann. Eine Bildverarbeitungseinrichtung der Steuereinrichtung kann zum Generieren und/oder Anpassen der virtuellen Darstellung der Maschinenumgebung und/oder des Bauwerks und/oder des Arbeitswerkzeugs in Abhängigkeit der eingespielten digitalen Daten aus dem Baustellendatenmodell aufweisen.

Vorteilhafterweise kann die Steuereinrichtung hierbei als Datenschnittstelle eine CAD-Schnittstelle umfassen, mittels derer in den Tabletcomputer CAD-Daten einspielbar sind, anhand derer auf dem Bildschirm durch das Simulationsmodul eine virtuelle Darstellung generierbar ist. Alternativ oder zusätzlich kann die Steuereinrichtung eine Bilddatenschnittstelle umfassen, mittels derer digitale Bilddaten einspielbar sind, anhand derer dann von der genannten Bildverarbeitungseinrichtung die virtuelle Darstellung der Maschinenumgebung und/oder des Arbeitswerkzeugs und/oder des Bauwerks generiert werden kann.

Vorteilhafterweise können auf dem Bildschirm aber nicht nur virtuelle Darstellungen angezeigt werden, sondern auch Ist-Bilder einer Kamera wiedergegeben werden. Um ein gleichermaßen realistisches wie informatives Bild anzuzeigen, anhand derer der auf den Bildschirm blickende Maschinenführer die Maschine intuitiv kontrollieren kann, kann die Steuereinrichtung in vorteilhafter Weiterbildung der Erfindung eine Anzeigesteuervorrichtung aufweisen, mittels derer eine überlagerte Bildschirmdarstellung nach Art eines Virtual Reality-Bilds auf dem Bildschirm generiert werden kann, das aus den empfangenen Bilddaten einer Kamera und den empfangenen digitalen Daten aus dem genannten Baustellendatenmodell BIM und somit aus einem Kamerabild der Maschinenumgebung einerseits und einer virtuellen Darstellung der Maschinenumgebung bzw. eines Bauwerkteils andererseits zusammengesetzt ist.

Bei einem solchen, zusammengesetzten Virtual Reality-Bild, das auf dem Bildschirm angezeigt und ggfs. durch die zuvor erläuterten Touchscreen-Anzeigeelemente zum Eingeben von Steuerbefehlen angereichert wird, kann bspw. das von einer oder mehreren Kameras bereitgestellte Ist-Bild einer Baustelle durch Konturen eines erst noch zu erstellenden Bauwerks ergänzt werden, sodass der Maschinenführer genau weiß, wohin ein jeweiliges Touchscreen-Anzeigeelement, insbesondere die genannte Arbeitsbereichsgrenze zu verfahren ist. Hierbei können auch im Ist-Bild bereits vorhandene Bauwerkskonturen und virtuelle Bauwerkskonturen, die dem nächsten Arbeitsschritt entsprechen, ergänzt werden, sodass auf dem Bildschirm im dargestellten Ist-Bild die im nächsten Arbeitsschritt zu errichtende Kontur angezeigt wird.

Alternativ oder zusätzlich können bspw. auch in das Kamera-Ist-Bild der Arbeitsumgebung der zu steuernden Maschine bestimmte Positionen wie bspw. eine Anlieferungsstation für Bauteile, ein Lagerplatz für Komponenten oder Begrenzungen des zulässigen Arbeitsbereichs eingeblendet werden.

Die kameragenerierte Ist-Darstellung der Arbeitsumgebung der Maschine kann ein zyklisch aktualisiertes Bild, das nach Art einer Webcam bereitgestellt wrid, oder auch ein kontinuierlich gestreamtes Livebild sein.

Eine solche echte, kameragenerierte Darstellung der Maschinenumgebung und/oder des Arbeitswerkzeugs kann insbesondere in Form eines Livebilds bzw. fernsehbildartigen Videobilds erzeugt werden, wobei von der zumindest einen Kamera an der ferngesteuerten Maschine ein entsprechendes Videosignal zu der Steuereinrichtung übertragen und von derenBildschirm wiedergegeben wird.

Die Erfindung wird nachfolgend anhand eines bevorzugten Ausführungsbeispiels und zugehöriger Zeichnungen näher erläutert. In den Zeichnungen zeigen:
- Fig. 1:: eine perspektivische Darstellung einer Baumaschine in Form eines Krans auf einer Baustelle, die für den Kran Arbeitsbereichsgrenzen erfordert,
- Fig. 2:: eine schematische Darstellung des Touchscreen-Bildschirms der Steuereinrichtung des Krans aus Fig. 1, wobei die Teilansichten a bis d verschiedene Bildschirmdarstellungen für die Einstellung der Arbeitsbereichsgrenzen auf dem Touchscreen-Bildschirm in verschiedenen Einstellschritten zeigt,
- Fig. 3:: eine Darstellung der Bildschirmansicht im Kranbetrieb, die neben der Darstellung relevanter Sensorwerte auch die Darstellung der eingestellten Arbeitsbereichsbegrenzung und die Annäherung des Krans an diese Grenze zeigt, und
- Fig. 4:: eine schematische Darstellung eines auf dem Touchscreen-Bildschirm der Steuereinrichtung des Krans aus den vorhergehenden Figuren dargestellten maschinenlesbaren Codes, bei dessen Einlesen durch ein mobiles Endgerät auf dem mobilen Endgerät zusätzliche Informationen angezeigt werden.

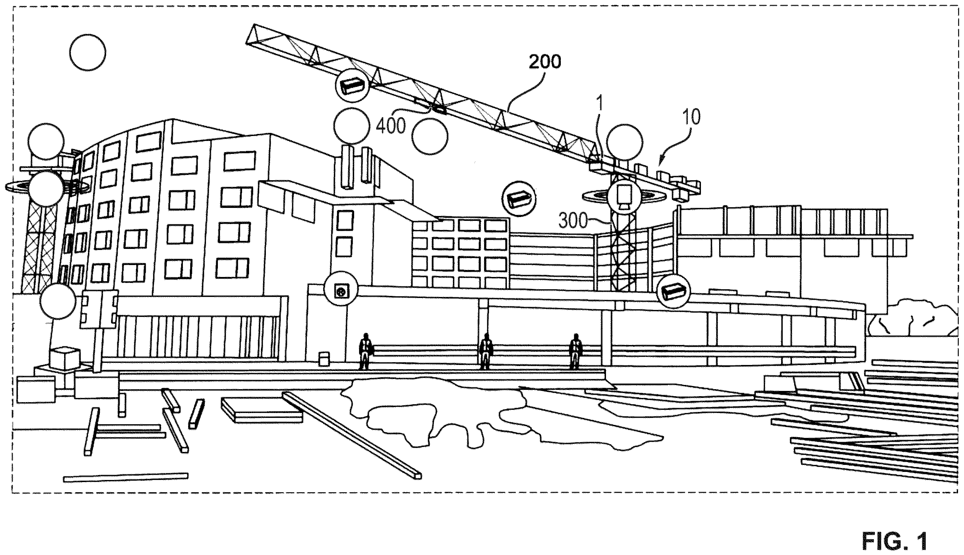

Wie Figur 1 zeigt, kann als Materialumschlags- und Baumaschine ein Kran 10 vorgesehen sein, der auf einer Baustelle 100 eingesetzt wird. Die auf der Baustelle 100 zu errichtenden Gebäude, aber auch andere Materialumschlags- und/oder Baumaschinen wie andere Krane, Seilbagger und dergleichen bilden für die Bewegungen des Krans 10 Hindernisse. Um Kollisionen zu verhindern, werden für den Kran 10 Arbeitsbereichsgrenzen vorgegeben, bei deren Erreichen oder Überschreiten eine oder mehrere Antriebsvorrichtungen des Krans 10, mit denen der Kran 10 verstellt wird, abgeschaltet oder zumindest verlangsamt werden.

Wie Figur 1 zeigt, kann der Kran 10 beispielsweise als Turmdrehkran ausgebildet sein, dessen Ausleger 200 von einem Turm 300 getragen wird, wobei der Turm zusammen mit dem Ausleger oder der Ausleger 200 relativ zum Turm 300 um eine aufrechte Achse von einem Drehwerksantrieb verdreht werden kann. An dem Ausleger 200 kann eine nur angedeutete Laufkatze 400 gelagert sein, die entlang der Längsachse des Auslegers 200 durch einen Katzantrieb verfahrbar ist. Von der Laufkatze 400 läuft ein Hubseil mit einem Lasthaken ab, welches anhebbar und absenkbar ist, indem das Hubseil von einem Hubwerksantrieb aufgespult bzw. abgespult wird.

Um die genannten Arbeitsbereichsgrenzen einzuhalten, kann eine elektronische Steuereinrichtung 1 einen oder mehrere der genannten Antriebe, das heißt beispielsweise den Drehwerksantrieb und/oder den Katzfahrantrieb und/oder den Hubwerksantrieb stillsetzen und vor Erreichen einer Arbeitsbereichsgrenze verlangsamen. Die genannte Steuereinrichtung 1 kann elektronisch ausgebildet sein und einen Mikroprozessor oder einen anderen Prozessor aufweisen, der aus einer elektronischen Speichereinrichtung einen darin gespeicherten Programmbaustein abarbeiten kann. Die genannte Steuereinrichtung 1 kann Teil der in den Kran 10 integrierten Kransteuerung sein.

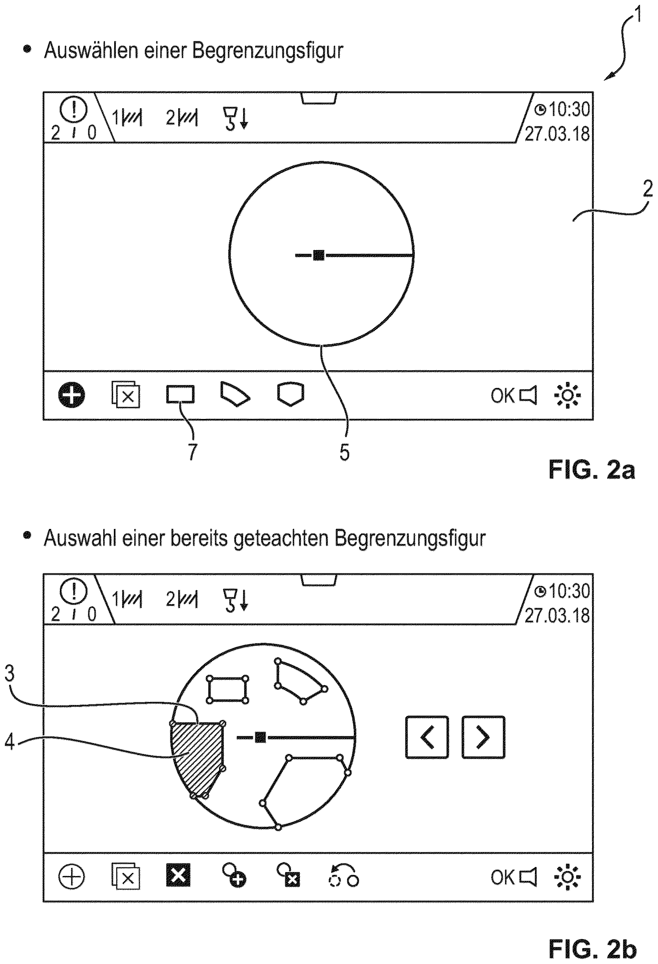

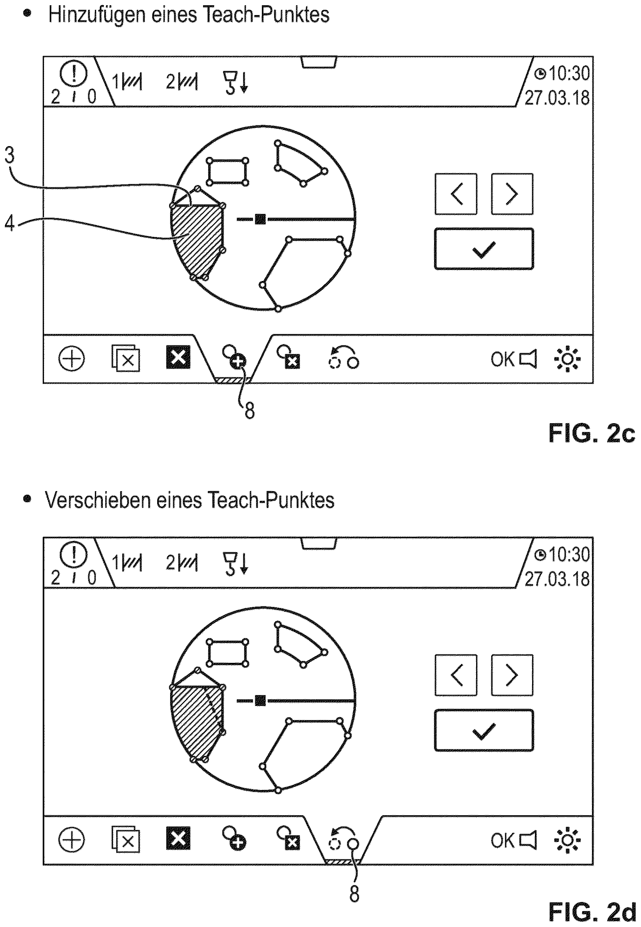

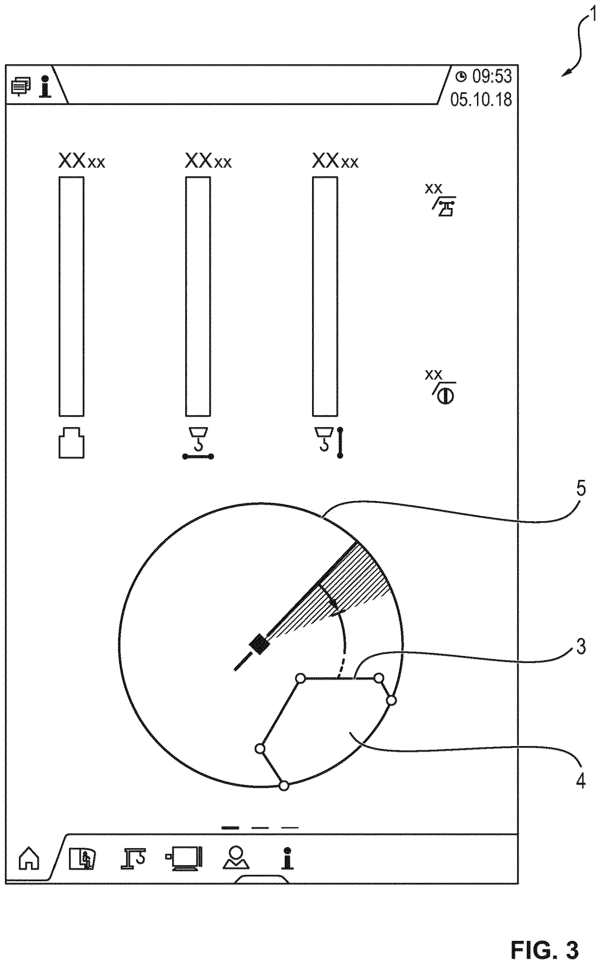

Wie Figur 2 und Figur 3 zeigt, umfasst die Steuereinrichtung 1 einen Bildschirm 2 mit Touchscreen-Funktion, auf dem verschiedene Touchscreen-Anzeigeelemente angezeigt und durch Berühren des Bildschirms betätigt bzw. angesteuert werden können.

Um eine Arbeitsbereichsgrenze 3 bzw. einen ganzen Begrenzungsbereich 4 einzurichten, wird auf dem Bildschirm 2 der Kran 10 und dessen theoretisch möglicher Arbeitsbereich 5 dargestellt. Bei dem beispielhaft dargestellten Turmdrehkran ist der theoretisch mögliche Arbeitsbereich 5 in einer Draufsicht betrachtet ein Kreis, der von der maximal möglichen Ausladung der Laufkatze 400 bestimmt wird, die im Wesentlichen der Länge des Auslegers 200 entspricht, vgl. Figur 2a.

Aus Gründen der Übersichtlichkeit weggelassen, gleichwohl aber auf dem Bildschirm 2 dargestellt ist ein Bild bzw. eine Darstellung der Kranumgebung, die wie Figur 1 zeigt, eine Baustelle mit den dort zu errichtenden Gebäuden, Zufahrtswegen, anderen Kranen und dergleichen sein kann. Ein solches Bild der Arbeits- bzw. Maschinenumgebung, das mit der in Figur 2 dargestellten Arbeitsbereichsgrenze bzw. dem Begrenzungsbereich 4 überlagert sein kann, kann ein Ist-Bild der Maschinen- bzw. Arbeitsumgebung und/oder eine virtuelle Darstellung der Arbeitsumgebung bzw. des zu erstellenden Bauwerks und/oder anderer, für den Arbeitsvorgang hilfreicher Bauteile oder Informationen sein.

Hierzu kann der Bildschirm 2 bzw. die Steuereinrichtung 1 beispielsweise über einen Router mit einem BIM, das heißt einem sogenannten Baustellendatenmodell verbunden werden, das in der Steuereinrichtung 1 selbst abgelegt sein kann oder auf das die Steuereinrichtung 1 über den genannten Router oder andere Datenkommunikationsmittel Zugriff hat. Über eine entsprechende Datenschnittstelle können der Steuereinrichtung 1 aus dem Baustellendatenmodell BIM entsprechende digitale Bauwerks- und/oder Baustelleninformationen oder andere relevante digitale Informationen eingespielt werden, die auf dem Bildschirm 2 angezeigt, insbesondere mit der einzustellenden Arbeitsbereichsgrenze 3 überlagert werden können. Insbesondere können anhand der genannten BIM-Daten virtuelle Darstellungen des zu errichtenden Bauwerks und/oder der Arbeitsumgebung des Krans dargestellt werden.

Alternativ oder zusätzlich zu einer solchen virtuellen Darstellung kann auf dem Bildschirm 2 jedoch auch eine echte, kameragenerierte oder durch eine sonstige bildgebende Sensorik generierte Darstellung der Kranumgebung und/oder des Lasthakens verwendet werden. Hierzu kann beispielsweise am Kran 10 zumindest eine Kamera montiert sein, deren Live-Bilder auf dem Bildschirm 2 übertragen werden. Eine solche Kamera kann beispielsweise an der Kranführerkabine oder einem anderen Maschinenführerstand montiert sein und vorteilhafterweise zumindest näherungsweise eine Blickachse haben, die der Blickachse eines Kranführers in der Kranführerkabine bzw. eines Maschinenführers entspricht und/oder von dem Maschinenführerstand zum Arbeitswerkzeug - im Falle des Krans 10 zum Lasthaken - hin geht.

Alternativ oder zusätzlich können aber auch andere Kameras und/oder Darstellungen aus anderen Perspektiven aufgenommen und an den Bildschirm 2 übertragen werden, um dort zusammen mit der Arbeitsbereichsgrenze 3 angezeigt zu werden. Beispielsweise kann eine Flugdrohne verwendet werden, die mit zumindest einer Kamera oder einem anderen bildgebenden Sensor ausgerüstet ist und ferngesteuert zusammen mit und/oder relativ zum Kran 10 bewegt werden kann.

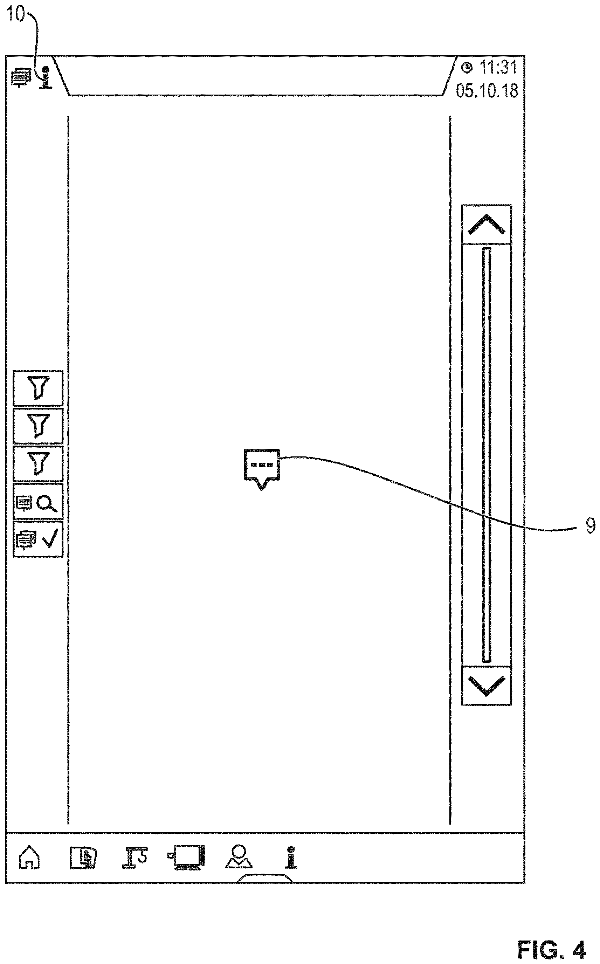

Wie Figur 4 zeigt, kann im Arbeitsbetrieb der Maschine die aktuelle Stellung des Krans 10, insbesondere des Auslegers 200 relativ zu der Arbeitsbereichsgrenze 3 und/oder dem Begrenzungsbereich 4 in der Arbeitsumgebung und/oder im theoretischen Arbeitsbereich 5 angezeigt werden, um den Maschinenführer stets aktuell zu zeigen, wie nahe sich die Maschine an der Arbeitsbereichsgrenze 3 befindet. Wie Figur 4 zeigt, können weitere, relevante Betriebsparameter auf dem Bildschirm 2 angezeigt werden, beispielsweise in Form von Balkendiagrammen, die beispielsweise Sensorwerte wie die Ausladung der Laufkatze 400, die Senktiefe des Lasthakens oder die Hublast anzeigen.

Um die Arbeitsbereichsgrenze 3 einzustellen oder zu verändern, kann zunächst die Arbeitsbereichs-Begrenzungsfunktion durch Berühren des Touchscreen-Bildschirms 2 bzw. eines darauf angeordneten Funktionssymbols aufgerufen werden. Wie Figur 4 zeigt, können beispielsweise an einem unteren Rand verschiedene Funktionssymbole 6 verschiedene, auswählbare Steuerungsfunktionen in Form jeweils eines Touchscreen-Anzeigeelements visualisieren, sodass ein Maschinenführer durch Antippen des relevanten Funktionssymbols 6 die gewünschte Steuerungsfunktion auswählen kann.

Nach Auswahl der Arbeitsbereichs-Begrenzungsfunktion zeigt die Steuervorrichtung 1 auf dem Bildschirm 2 zunächst den theoretischen Arbeitsbereich 5 des Krans 10 zusammen mit einer Darstellung des Krans 10 und der gegebenenfalls überlagerten Darstellung der Arbeitsumgebung dar, vgl. Figur 2a.

Um eine Arbeitsbereichsgrenze 3 hinsichtlich der benötigten Konturierung möglichst effizient einzustellen, werden auf dem Bildschirm 2 verschiedene Auswahlkonturen 7 wiederum in Form von Touchscreen-Anzeigeelementen, die auf Berührung des Bildschirms reagieren, angeboten bzw. dargestellt. Diese Auswahlkonturen 7 können vorteilhafterweise in einer Randleiste des Bildschirms 2 dargestellt werden und beispielsweise eine rechteckige Auswahlkontur, eine bogenstreifenförmige Auswahlkontur 7 und eine sektorenförmige Auswahlkontur 7 umfassen. Es versteht sich, dass gegebenenfalls noch weitere, anders geformte Auswahlkonturen bereitgehalten werden können.

Stellt der Maschinenführer anhand des dargestellten Bilds der Arbeitsumgebung oder auch aufgrund eigener Wahrnehmung aus der Kranführerkabine heraus fest, dass beispielsweise für eine Arbeitsbereichsgrenze 3, mit der Kollisionen mit einem Gebäude verhindert werden sollen, die rechteckige Auswahlkontur 7 am besten passt, wird diese Auswahlkontur 7 durch Berühren des Bildschirms 2 ausgewählt und in dem Arbeitsbereich 5 angezeigt, vgl. Figur 2b.

Nach diesem Vorkonfigurationsschritt kann die Arbeitsbereichsgrenze 3 hinsichtlich ihrer Position relativ zum Kran 10 und/oder relativ zu der Arbeitsumgebung positioniert, in ihrer Größe verändert und hinsichtlich ihrer Form verändert werden.

Beispielsweise kann zum Positionieren der vorausgewählten Arbeitsbereichsgrenze 3 der von der Arbeitsbereichsgrenze 3 umgebene Begrenzungsbereich 4 mit zwei Fingern gleichzeitig angetippt werden und sodann durch Entlangwischen auf dem Bildschirm 2 mit beiden Fingern in eine neue Position verschoben werden.

Um die Konturierung bzw. Form der Arbeitsbereichsgrenze 3 zu verändern, kann beispielsweise ein Konturpunkt 3a der Arbeitsbereichsgrenze 3 angetippt und beispielsweise längere Zeit berührt gehalten werden, um die Steuereinrichtung 1 bzw. den Visualisierungs-Steuerbaustein zum Steuern der Bildschirmvisualisierung anzuzeigen bzw. anzuweisen, dass eine Konturveränderung erfolgen soll. Daraufhin kann der mit einem Finger berührte Konturpunkt 3a beispielsweise durch Entlangwischen auf dem Bildschirm 2 zu einer neuen Position hin gezogen werden, vgl. Figur 2d.

Alternativ oder zusätzlich kann eine Veränderung der Kontur der Arbeitsbereichsgrenze 3 auch dadurch erzielt werden, dass ein zusätzlicher Konturpunkt gesetzt wird, beispielsweise durch Antippen und gegebenenfalls längeres Halten eines Punktes außerhalb des vorkonfigurierten Begrenzungsbereichs 4 und innerhalb des Arbeitsbereichs 5, vgl. Figur 2c. Um der Steuereinrichtung 1 bzw. dem Visualisierungs-Steuerbaustein anzuzeigen, dass ein neuer Konturpunkt gesetzt werden soll, kann gegebenenfalls verlangt werden, dass zuvor der Begrenzungsbereich 4, zu welchem ein zusätzlicher Konturpunkt gesetzt werden soll, berührt wird und gegebenenfalls gehalten bleibt, um den relevanten Begrenzungsbereich 4 zu aktivieren.

Alternativ oder zusätzlich kann das Hinzufügen eines weiteren Konturpunkts und/oder das Verschieben eines existenten Konturpunkts aber auch durch Ansteuern bzw. Berühren eines entsprechenden Funktionssteuersymbols angezeigt werden. Wie die Figuren 2c und 2d zeigen, kann beispielsweise in einer Randleiste während des Einstellvorgangs bzw. zum Einstellbildschirm eine Darstellung verschiedener Einstellfunktionen durch entsprechende Funktionssymbole 8 vorgesehen sein, um durch Berühren des entsprechenden Funktionssymbols 8 die entsprechende Einstelloption auszuwählen. Die genannten Funktionssymbole 8 sind vorteilhafterweise wiederum in Form von Touchscreen-Anzeigeelementen ausgebildet, die auf Berühren des Bildschirms 2 reagieren. In der Bildschirmdarstellung gemäß Figur 2c wurde das Funktionssymbol 8 zum Hinzufügen eines Konturpunkts für die Arbeitsbereichsgrenze 3 ausgewählt, was dann durch Hervorheben des Symbols bzw. Ausgrenzen aus der Symbolleiste dargestellt wird. Gemäß Figur 2d wurde das Funktionssymbol 8 zum Verschieben eines schon existenten Konturpunkts ausgewählt, woraufhin dann durch Berühren eines Konturpunkts in der dargestellten Arbeitsbereichsgrenze 3 dieser Konturpunkt verschoben werden kann.

Ist die Arbeitsbereichsgrenze 3 bzw. der Begrenzungsbereich 4 auf dem Touchscreen-Bildschirm 2 in der gewünschten Weise positioniert, konturenmäßig geformt und in der Größe eingestellt wie gewünscht, kann der Steuereinrichtung 1 durch Betätigen einer Eingabetaste, die wiederum als Touchscreen-Anzeigeelement beispielsweise in Form eines Häkchens angezeigt werden kann, signalisiert, dass die Einstellung der Arbeitsbereichsgrenze 3 finalisiert wurde, übernimmt die Steuereinrichtung 1 die auf dem Bildschirm 2 konfigurierte Arbeitsbereichsgrenze 3 und rechnet diese in entsprechende Werte für die Arbeitsbereichsbegrenzungsfunktion um, sodass die Steuereinrichtung 1 bei Annäherung eines relevanten Maschinenteils an die genannte Arbeitsbereichsgrenze 3, beispielsweise Annäherung des Lasthakens an eine Gebäudekontur oder Annäherung des Auslegers 200 an den Turm eines anderen Krans den zugehörigen Stellantrieb abbremsen und abschalten kann.

Ergeben sich bei der Einstellung der Arbeitsbereichsgrenze 3 oder beim Einstellen anderer relevanter Funktionsparameter Probleme, bietet der Bildschirm 2 eine zusätzliche Hilfe-Funktion an, die dem Maschinenführer zusätzliche Informationen liefert. Wie Figur 4 zeigt, kann auf dem Bildschirm 2 ein maschinenlesbarer Code 9 beispielsweise in Form eines QR-Codes angezeigt werden. Wird der genannte maschinenlesbare Code 9 durch die Kamera eines mobilen Endgeräts wie beispielsweise eines Mobiltelefons oder eines Tablet-Computers eingescannt, veranlasst der eingescannte Code 9 das mobile Endgerät dazu, eine Unterstützungs-Ressource aufzurufen, die in dem mobilen Endgerät selbst gespeichert, insbesondere aber auch extern von einem Webserver oder einem anderen Datenbankgerät bereitgehalten wird. Beispielsweise kann der eingescannte Code 9 das mobile Endgerät dazu veranlassen, eine entsprechende Internetseite aufzurufen, auf der die relevante Information bereitgehalten wird, sodass die genannte Information dann auf dem Endgerät angezeigt wird.

Die Anzeige des Codes 9 auf dem Bildschirm 2 kann automatisiert erfolgen, insbesondere in Abhängigkeit einer fehlerhaften Steuereingabe oder einer unerwarteten Steuereingabe. Werden beispielsweise bei der zuvor erläuterten Einstellung der Arbeitsbereichsgrenze 3 in der Bildschirmdarstellung gemäß Figur 2b oder Figur 2c die Funktionssymbole 8 für Generieren eines neuen Konturpunkts und Verschieben eines existenten Konturpunkts gleichzeitig berührt, kann der Bildschirm 2 einen QR-Code 9 darstellen, der ein den Code einscannendes mobiles Endgerät dazu veranlasst, eine Hilfeseite zum Betätigen der Funktionssymbole 8 anzuzeigen.

Insbesondere kann auch jede Fehlermeldung, die auf dem Bildschirm 2 ausgegeben wird, mit einem solchen maschinenlesbaren Code 9 zusammen dargestellt werden.

Alternativ oder zusätzlich zu einer solchermaßen automatisierten Code-Darstellung kann der maschinenlesbare Code auch durch den Maschinenführer willentlich abgerufen bzw. auf dem Bildschirm 2 dargestellt werden, beispielsweise indem ein Hilfe- oder Informationssymbol 10, das auf dem Bildschirm 2 in Form eines Touchscreen-Anzeigeelements dargestellt wird, berührt wird. Ein solches Hilfesymbol 10 kann zu jedem Einstellschritt bzw. zu jeder Darstellung auf dem Bildschirm 2 angezeigt werden, vgl. beispielsweise Figur 4.

## Patentansprüche

1. Verfahren zum Steuern einer Materialumschlags- und/oder Baumaschine wie Kran oder Seilbagger, wobei auf einem Bildschirm (2) einer Steuereinrichtung (1) mit Touchscreen-Funktion verschiedene Steuerfunktionen durch Berühren eines Steuerfunktionssymbols (6) ausgewählt und Funktionsparameter einer jeweils ausgewählten Steuerfunktion eingestellt werden, **dadurch gekennzeichnet, dass** von einer Bedienhilfe auf dem Bildschirm (2) ein maschinenlesbaren Code (9) bereitgestellt wird, bei dessen Einscannen durch ein mobiles Endgerät das mobile Endgerät dazu veranlasst wird, zusätzliche Informationen zu der ausgewählten Steuerfunktion aufzurufen und auf dem mobilen Endgerät anzuzeigen.

2. Verfahren nach dem vorhergehenden Anspruch, wobei eine Arbeitsbereichsgrenze (3) einer Arbeitsbereichs-Begrenzungsfunktion zum automatischen Abschalten und/oder Verlangsamen zumindest eines Stellantriebs bei Erreichen der Arbeitsbereichsgrenze (3) auf dem Bildschirm (2) zusammen mit einer Darstellung der Materialumschlags- und/oder Baumaschine und/oder deren Arbeitsumgebung in Form eines Touchscreen-Anzeigeelements angezeigt wird und durch Berühren und Verschieben der Arbeitsbereichsgrenze (3) auf dem Bildschirm (2) relativ zu der Darstellung der Materialumschlags- und/oder Baumaschine und/oder deren Arbeitsumgebung eingestellt wird, wobei die Kontur der Arbeitsbereichsgrenze (3) durch Berühren einer von mehreren auf dem Bildschirm (2) angezeigten Auswahlkonturen (7) vorkonfiguriert wird, wobei die Kontur der Arbeitsbereichsgrenze (3) durch Antippen eines Konturpunkts der Arbeitsbereichsgrenze (3) und Verschieben des angetippten Konturpunkts durch Entlangwischen auf dem Bildschirm (2) verändert wird, wobei die Kontur der Arbeitsbereichsgrenze (3) durch Hinzufügen eines zusätzlichen Konturpunkts verändert wird, welcher zusätzliche Konturpunkt durch Antippen eines Bildschirmpunkts beabstandet von der bisher angezeigten Arbeitsbereichsgrenze (3) erzeugt wird, wobei die Arbeitsbereichsgrenze (3) durch Berühren auf dem Bildschirm (2) und Entlangwischen auf dem Bildschirm (2) relativ zur Materialumschlags- und/oder Baumaschine verschoben und neu positioniert wird, wobei zwischen einem Verschieben der Arbeitsbereichsgrenze (3) und einem Verändern der Form der Arbeitsbereichsgrenze (3) durch unterschiedliches Berühren des Bildschirms (2) unterschieden wird, insbesondere durch ein- oder mehrfaches Antippen und/oder durch Berühren mit einem oder mehreren Fingern.

3. Verfahren nach einem der vorhergehenden Ansprüche, wobei der maschinenlesbare Code (9) automatisch bei Eingabe eines fehlerhaften und/oder unvorhergesehenen Steuerbefehls auf dem Bildschirm (2) der Steuereinrichtung angezeigt wird.

4. Verfahren nach einem der vorhergehenden Ansprüche, wobei der machinenlesbare Code (9) bei Berühren eines Hilfs- und/oder Informationssymbols (10) angezeigt wird, das auf dem Bildschirm (2) in Form eines Touchscreen-Anzeigeelements angezeigt wird.

5. Verfahren nach einem der vorhergehenden Ansprüche, wobei die auf dem Bildschirm (2) angezeigte Darstellung der Arbeitsumgebung der Materialumschlags- und/oder Baumaschine auf Basis von Bilddaten von einer Kamera (220) und/oder digitale Daten aus einem Bauwerkdatenmodell (BIM) generiert wird, und Eingabemittel zum Eingeben von Steuerbefehlen zumindest zeitweise gleichzeitig zur Darstellung der Maschinenumgebung und/oder des Arbeitswerkzeugs auf dem Bildschirm (4) angezeigt werden.

6. Verfahren nach dem vorhergehenden Anspruch, wobei von einer Anzeigesteuervorrichtung eine überlagerte Bildschirmdarstellung nach Art eines Virtual-Reality-Bilds auf dem Bildschirm generiert wird, das aus den empfangenen Bilddaten der Kamera (220) und den empfangenen digitalen Daten aus dem Bauwerkdatenmodell (BIM) und somit aus einem Kamerabild der Maschinenumgebung und einer virtuellen Darstellung der Maschinenumgebung und/oder eines Bauwerkteils zusammengesetzt wird.

7. Vorrichtung zum Steuern einer Bau- und/oder Materialumschlagsmaschine wie Kran oder Seilbagger, mit einer Steuervorrichtung (1), die einen Bildschirm (2) mit Touchscreen-Funktion umfasst, wobei auf dem Bildschirm (2) verschiedene Steuerfunktionen durch Steuerfunktionssymbole (6) dargestellt und durch Berühren eines der mehreren Steuerfunktionssymbole (6) auswählbar sind, wobei auf dem Bildschirm (2) ferner Auswahlmittel zum Einstellen von Funktionsparametern einer jeweils ausgewählten Steuerfunktion vorgesehen sind, **dadurch gekennzeichnet, dass** eine Bedienhilfe auf dem Bildschirm (2) einen maschinenlesbaren Code (9) umfasst, der bei Einscannen durch ein mobiles Endgerät das mobile Endgerät dazu veranlasst, zusätzliche Informationen zu der ausgewählten Steuerfunktion aufzurufen und auf dem mobilen Endgerät anzuzeigen.

8. Vorrichtung nach dem vorhergehenden Anspruch, wobei die Steuereinrichtung (1) eine Arbeitsbereichsbegrenzungsfunktion umfasst, die dazu ausgebildet ist, eine Arbeitsbereichsgrenze (3) auf dem Bildschirm (2) zusammen mit einer Darstellung der Materialumschlags- und/oder Baumaschine (1) und/oder deren Arbeitsumgebung in Form eines Touchscreen-Anzeigeelements anzuzeigen und durch Berühren und Verschieben der Arbeitsbereichsgrenze (3) auf dem Bildschirm (2) relativ zu der Materialumschlags- und/oder Baumaschine einzustellen, wobei die Arbeitsbereichsbegrenzungsfunktion der Steuereinrichtung (1) dazu ausgebildet ist, die Kontur der Arbeitsbereichsgrenze (3) durch Berühren einer von mehreren auf dem Bildschirm (2) angezeigten Auswahlkonturen (7) vorzukonfigurieren, wobei die Arbeitsbereichsbegrenzungsfunktion der Steuereinrichtung (1) dazu ausgebildet ist, die Kontur der Arbeitsbereichsgrenze (3) durch Antippen eines Konturpunkts der Arbeitsbereichsgrenze (3) und Verschieben des angetippten Konturpunkts durch Entlangwischen auf dem Bildschirm (2) zu verändern, wobei die Arbeitsbereichs-Begrenzungsfunktion der Steuereinrichtung (1) dazu ausgebildet ist, die Kontur der Arbeitsbereichsgrenze (3) durch Hinzufügen eines zusätzlichen Konturpunkts zu verändern, welcher zusätzliche Konturpunkt durch Antippen eines Bildschirmpunkts beabstandet von der bisher angezeigten Arbeitsbereichsgrenze (3) erzeugt wird, wobei die Arbeitsbereichs-Begrenzungsfunktion der Steuereinrichtung (1) dazu ausgebildet ist, die Arbeitsbereichsgrenze (3) durch Berühren auf dem Bildschirm (2) und Entlangwischen auf dem Bildschirm (2) relativ zur Materialumschlags- und/oder Baumaschine zu verschieben und neu zu positionieren, wobei die Arbeitsbereichs-Begrenzungsfunktion der Steuereinrichtung (1) dazu ausgebildet ist, zwischen einem Verschieben der Arbeitsbereichsgrenze (3) und einem Verändern der Form der Arbeitsbereichsgrenze (3) durch unterschiedliches Berühren des Bildschirms (2) zu unterscheiden, insbesondere durch ein- oder mehrfaches Antippen und/oder durch Berühren mit einem oder mehreren Fingern.

9. Vorrichtung nach einem der beiden vorhergehenden Ansprüche, wobei der maschinenlesbare Code (9) als QR-Code ausgebildet ist.

10. Vorrichtung nach einem der Ansprüche 7-9, wobei die Bedienhilfe dazu ausgebildet ist, den genannten maschinenlesbaren Code (9) automatisch bei Eingabe eines fehlerhaften und/oder unvorhergesehenen Steuerbefehls anzuzeigen.

11. Vorrichtung nach einem der vorhergehenden Ansprüche 7 bis 10, wobei die Bedienhilfe dazu ausgebildet ist, den maschinenlesbaren Code (9) bei Berühren eines Hilfs- und/oder Informationssymbols (10) anzuzeigen, das auf dem Bildschirm (2) in Form eines Touchscreen-Anzeigeelements angezeigt wird.

12. Vorrichtung nach einem der vorhergehenden Ansprüche 7 bis 11, wobei eine Anzeigesteuervorrichtung zum Generieren einer überlagerten Bidschirmdarstellung nach Art eines Virtual-Reality-Bilds auf dem Bildschirm (2), das aus den empfangenen Bilddaten der Kamera und den empfangenen digitalen Daten aus dem Bauwerkdatenmodell (BIM) und somit aus einem Kamerabild der Maschinenumgebung und einer virtuellen Darstellung der Maschinenumgebung und/oder eines Bauwerkteils zusammengesetzt ist, vorgesehen ist.

13. Materialumschlags- und/oder Baumaschine, insbesondere Kran oder Seilbagger, mit einer Vorrichtung zum Steuern, die gemäß einem der vorhergehenden Ansprüche 7 bis 12 ausgebildet ist.

## Claims

1. Method for controlling a material handling and/or construction machine such as a crane or cable excavator, wherein different control functions are selected on a screen (2) of a controller (1) with touchscreen function by touching a control function symbol (6) and functional parameters of a respectively selected control function are set, **characterized in that** a machine-readable code (9) is provided by an operating aid on the screen (2), the scanning of which code by a mobile terminal causes the mobile terminal to call up additional information on the selected control function and to display it on the mobile terminal.

2. Method according to the preceding claim, wherein a working region boundary (3) of a working region boundary function for automatically deactivating and/or slowing down at least one actuator is displayed on the screen (2) together with a display of the material handling and/or construction machine and/or the work surroundings in the form of a touchscreen display element when the working region boundary (3) is reached and is adjusted by touching and moving the working region boundary (3) on the screen (2) relative to the display of the material handling and/or construction machine and/or the work surroundings thereof, wherein the contour of the working region boundary (3) is preconfigured by touching one of a plurality of selection contours (7) displayed on the screen (2), wherein the contour of the working region boundary (3) is changed by tapping a contour point of the working region boundary (3) and moving the tapped contour point by wiping along the screen (2), wherein the contour of the working region boundary (3) is changed by adding an additional contour point, which additional contour point is created by tapping a screen point spaced from the previously displayed working region boundary (3), wherein the working region boundary (3) is moved and newly positioned relative to the material handling and/or construction machine by touching on the screen (2) and wiping along the screen (2), wherein a distinction is made between moving the working region boundary (3) and changing the shape of the working region boundary (3) by touching the screen (2) differently, in particular by tapping once or several times and/or by touching with one or more fingers.

3. Method according to one of the preceding claims, wherein the machine-readable code (9) is automatically displayed on the screen (2) of the controller upon input of an erroneous and/or unforeseen control command.

4. Method according to one of the preceding claims, wherein the machine-readable code (9) is displayed upon touching an auxiliary and/or information symbol (10) displayed on the screen (2) in the form of a touch screen display element.

5. Method according to any of the preceding claims, wherein the representation of the work surroundings of the material handling and/or construction machine displayed on the screen (2) is generated on the basis of image data from a camera (220) and/or digital data from a building information model (BIM), and input means for inputting control commands are displayed on the screen (4) at least at times simultaneously with the representation of the machine surroundings and/or the work tool.

6. Method according to the preceding claim, wherein a superimposed screen representation in a manner of a virtual reality image is generated on the screen by a display controller, that is assembled from the received image data of the camera (220) and the received digital data from the building information model (BIM) and thus from a camera image of the machine surroundings and a virtual representation of the machine surroundings and/or a building part.

7. Device for controlling a construction and/or material handling machine, such as a crane or cable excavator with a controller (1) which comprises a screen (2) with a touch screen function, wherein different control functions are represented on the screen (2) by control function symbols (6) and can be selected by touching one of the plurality of control function symbols (6), wherein selection means are further provided on the screen (2) for setting functional parameters of a respectively selected control function, **characterized in that** an operating aid on the screen (2) comprises a machine-readable code (9) which, when scanned by a mobile terminal, causes the mobile terminal to call up additional information on the selected control function and display it on the mobile terminal.

8. Device according to the preceding claim, wherein the controller (1) comprises a working region boundary function which is adapted to display a working region boundary (3) on the screen (2) together with a representation of the material handling and/or construction machine (1) and/or the work surroundings thereof in the form of a touch screen display element and to adjust the working region boundary (3) on the screen (2) relative to the material handling and/or construction machine by touching and moving the working region boundary (3), wherein the working region boundary function of the controller (1) is adapted to preconfigure the contour of the working region boundary (3) by touching one of a plurality of selection contours (7) displayed on the screen (2), wherein the working region boundary function of the controller (1) is adapted to change the contour of the working region boundary (3) by tapping a contour point of the working region boundary (3) and moving the tapped contour point by wiping along the screen (2), wherein the working region boundary function of the controller (1) is adapted to change the contour of the working region boundary (3) by adding an additional contour point, which additional contour point is generated by tapping a screen point spaced from the previously displayed working region boundary (3), wherein the working region boundary function of the controller (1) is adapted to move and position the working region boundary anew (3) relative to the material handling and/or construction machine by touching on the screen (2) and wiping along the screen (2), wherein the working region boundary function of the controller (1) is adapted to distinguish between moving the working region boundary (3) and changing the shape of the working region boundary (3) by touching the screen (2) differently, in particular by tapping once or several times and/or by touching with one or more fingers.

9. Device according to one of the two preceding claims, wherein the machine-readable code (9) is formed as a QR code.

10. Device according to one of claims 7-9, wherein said operating aid is adapted to automatically display said machine-readable code (9) upon input of an erroneous and/or unpredictable control command.

11. Device according to one of the preceding claims 7 to 10, wherein said operating aid is adapted to display the machine-readable code (9) upon touching an auxiliary and/or information symbol (10) displayed on the screen (2) in the form of a touch screen display element.

12. Device according to any of the preceding claims 7 to 11, wherein provision is made for a display controller for generating a superimposed screen representation in the manner of a virtual reality image on the screen (2) composed of the received image data from the camera and the received digital data from the building information model (BIM) and thus of a camera image of the machine surroundings and a virtual representation of the machine surroundings and/or a building part.

13. Material handling and/or construction machine, in particular a crane or a cable excavator, comprising a control device configured according to any one of the preceding claims 7 to 12.

## Revendications

1. Procédé pour commander une machine de transbordement de matériaux et/ou de construction, telle qu'une grue ou un excavateur à câble, dans lequel différentes fonctions de commande sont sélectionnées en touchant un symbole de fonction de commande (6) et des paramètres de fonction d'une fonction de commande respectivement sélectionnée sont réglés sur un écran (2) d'un système de commande (1) avec une fonction d'écran tactile, **caractérisé en ce qu'**est fourni par une aide à l'utilisation sur l'écran (2) un code (9) lisible par machine, lors du scannage duquel par un terminal mobile, le terminal mobile est amené à appeler des informations supplémentaires concernant la fonction de commande sélectionnée et à les afficher sur le terminal mobile.

2. Procédé selon la revendication précédente, dans lequel une limite de zone de travail (3) d'une fonction de limitation de zone de travail destinée à désactiver automatiquement et/ou à ralentir au moins un actionneur, lorsque la limite de zone de travail (3) est atteinte, est affichée sur l'écran (2) conjointement avec une représentation de la machine de transbordement de matériaux et/ou de construction et/ou de son environnement de travail sous la forme d'un élément d'affichage d'écran tactile et est réglée en touchant et en décalant la zone de limite de travail (3) sur l'écran (2) par rapport à la représentation de la machine de transbordement de matériaux et/ou de construction et/ou de son environnement de travail, dans lequel le contour de la limite de zone de travail (3) est préconfiguré en touchant un de plusieurs contours de sélection (7) affichés sur l'écran (2), dans lequel le contour de la limite de zone de travail (3) est modifié en tapotant un point de contour de la zone de limite de travail (3) et en décalant le point de contour tapoté par un geste de balayage longitudinal sur l'écran (2), dans lequel le contour de la zone de limite de travail (3) est modifié en ajoutant un point de contour supplémentaire, lequel point de contour supplémentaire est produit à distance de la zone de limite de travail (3) affichée jusqu'à présent en tapotant un point de l'écran, dans lequel la zone de limite de travail (3) est décalée en touchant l'écran (2) et en effectuant un geste de balayage longitudinal sur l'écran (2) par rapport à la machine de transbordement de matériaux et/ou de construction et est repositionnée, dans lequel on distingue entre un décalage de la limite de zone de travail (3) et une modification de la forme de la limite de zone de travail (3) en touchant différemment l'écran (2), en particulier en tapotant une fois ou plusieurs fois et/ou en touchant avec un ou plusieurs doigts.

3. Procédé selon l'une quelconque des revendications précédentes, dans lequel le code (9) lisible par machine est affiché automatiquement sur l'écran (2) du système de commande lors de la saisie d'une instruction de commande erronée et/ou imprévue.

4. Procédé selon l'une quelconque des revendications précédentes, dans lequel le code (9) lisible par machine est affichée en touchant un symbole d'aide et/ou d'information (10), qui est affiché sur l'écran (2) sous la forme d'un élément d'affichage d'écran tactile.

5. Procédé selon l'une quelconque des revendications précédentes, dans lequel la représentation, affichée sur l'écran (2), de l'environnement de travail de la machine de transbordement de matériaux et/ou de construction est générée sur la base de données d'image d'une caméra (220) et/ou de données numériques provenant d'une modélisation de données d'ouvrage de construction (BIM), et des moyens de saisie destinés à saisir des instructions de commande sont affichés au moins par intermittence simultanément pour représenter l'environnement de machine et/ou l'outil de travail sur l'écran (4).

6. Procédé selon la revendication précédente, dans lequel est générée sur l'écran, par un dispositif d'affichage, une représentation d'écran superposée à la manière d'une image de réalité virtuelle, qui se compose des données d'image reçues de la caméra (220) et des données numériques reçues provenant de la modélisation de données d'ouvrage de construction (BIM) et ainsi d'une image de caméra de l'environnement de machine et d'une représentation virtuelle de l'environnement de machine et/ou d'une partie d'ouvrage de construction.

7. Dispositif pour commander une machine de construction et/ou de transbordement de matériaux, telle qu'une grue ou un excavateur à câble, avec un dispositif de commande (1), qui comprend un écran (2) avec une fonction d'écran tactile, dans lequel différentes fonctions de commande sont représentées par des symboles de fonction de commande (6) sur l'écran (2) et peuvent être sélectionnées en touchant un des plusieurs symboles de fonction de commande (6), dans lequel en outre des moyens de sélection destinés à régler des paramètres de fonction d'une fonction de commande respectivement sélectionnée sont prévus sur l'écran (2), **caractérisé en ce qu'**une aide à l'utilisation sur l'écran (2) comprend un code (9) lisible par machine, qui amène, lors du scannage par un terminal mobile, le terminal mobile à appeler des informations supplémentaires concernant la fonction de commande sélectionnée et à les afficher sur le terminal mobile.

8. Dispositif selon la revendication précédente, dans lequel le système de commande (1) comprend une fonction de limitation de zone de travail, qui est réalisée pour afficher une limite de zone de travail (3) sur l'écran (2) conjointement avec une représentation de la machine de transbordement de matériaux et/ou de construction (1) et/ou son environnement de travail sous la forme d'un élément d'affichage d'écran tactile et pour la régler en touchant et en décalant la limite de zone de travail (3) sur l'écran (2) par rapport à la machine de transbordement de matériaux et/ou de construction, dans lequel la fonction de limitation de zone de travail du système de commande (1) est réalisée pour préconfigurer le contour de la limite de zone de travail (3) en touchant un de plusieurs contours de sélection (7) affichés sur l'écran (2), dans lequel la fonction de limitation de zone de travail du système de commande (1) est réalisée pour modifier le contour de la limite de zone de travail (3) en tapotant un point de contour de la limite de zone de travail (3) et en décalant le point de contour tapoté par un geste de balayage longitudinal sur l'écran (2), dans lequel la fonction de limitation de zone de travail du système de commande (1) est réalisée pour modifier le contour de la limite de zone de travail (3) en ajoutant un point de contour supplémentaire, lequel point de contour supplémentaire est produit à distance de la limite de zone de travail (3) affichée jusqu'à présent en tapotant un point d'écran, dans lequel la fonction de limitation de zone de travail du système de commande (1) est réalisée pour décaler la limite de zone de travail (3) en touchant l'écran (2) et en effectuant un geste de balayage longitudinal sur l'écran (2) par rapport à la machine de transbordement de matériaux et/ou de construction et la repositionner, dans lequel la fonction de limitation de zone de travail du système de commande (1) est réalisée pour distinguer entre un décalage de la limite de zone de travail (3) et une modification de la forme de la limite de zone de travail (3) en touchant différemment l'écran (2), en particulier en tapotant une fois ou plusieurs fois et/ou en touchant avec un ou plusieurs doigts.

9. Dispositif selon l'une quelconque des deux revendications précédentes, dans lequel le code (9) lisible par machine est réalisé en tant qu'un QR-code.

10. Dispositif selon l'une quelconque des revendications 7-9, dans lequel l'aide à l'utilisation est réalisée pour afficher ledit code (9) lisible par machine automatiquement lors de la saisie d'une instruction de commande erronée et/ou imprévue.

11. Dispositif selon l'une quelconque des revendications précédentes 7 à 10, dans lequel l'aide à l'utilisation est réalisée pour afficher le code (9) lisible par machine lorsque le symbole d'aide et/ou d'information (10) est touché, qui est affiché sur l'écran (2) sous la forme d'un élément d'affichage d'écran tactile.

12. Dispositif selon l'une quelconque des revendications précédentes 7 à 11, dans lequel un dispositif de commande d'affichage est prévu pour générer une représentation d'écran superposée à la manière d'une image de réalité virtuelle sur l'écran (2), qui se compose des données d'image reçues de la caméra et des données numériques reçues provenant de la modélisation de données d'ouvrage de construction (BIM) et ainsi provenant d'une image de caméra de l'environnement de machine et d'une représentation virtuelle de l'environnement de machine et/ou d'une partie d'ouvrage de construction.

13. Machine de transbordement de matériaux et/ou de construction, en particulier grue ou excavateur à câble, avec un dispositif de commande, qui est réalisé selon l'une quelconque des revendications précédentes 7 à 12.
